# EUROPÄISCHE PATENTANMELDUNG

(11) **EP 1 341 211 A2**
(43) Veröffentlichungstag der Anmeldung: **03.09.2003**
(21) Anmeldenummer: 03003492.0
(22) Anmeldetag: 14.02.2003
(51) Int. Cl.: H01L 21/00, H01L 21/302

(54) **Verfahren und Vorrichtung zur lichtinduzierten chemischen Behandlung eines Werkstückes**

(30) Priorität: 18.02.2002 DE 10206687
(71) Anmelder: Infineon Technologies AG, 81669 München (DE)
(72) Erfinder: Kröner, Friedrich, Dr., 9500 Villach (AT); Wistrela, Robert, 9020 Klagenfurt (AT)
(74) Vertreter: Banzer, Hans-Jörg, Dipl.-Ing.

(57) **Zusammenfassung**

Um ein Werkstück (1) fotochemisch zu behandeln, wird dieses unter der Einwirkung eines chemischen Stoffs (19) mit einem bestimmten Belichtungsmuster belichtet. Um den Stoff (19) sicher und kontrolliert mit dem Werkstück (1) in Berührung zu bringen, wird erfindungsgemäß eine Kammer (2) vorgeschlagen, deren Wand wenigstens zum Teil von einer Abbildungsplatte (12) gebildet wird, die ein Belichtungsmuster auf die Oberfläche des Werkstücks (1) fokussieren kann. Die Abbildungsplatte (12) ist vorzugsweise eine Mikrolinsenanordnung, die ein von einer außerhalb der Kammer (2) angeordneten Maske (6) erzeugtes Abbildungsmuster über eine bestimmte Entfernung hinweg auf die Oberfläche des Werkstücks (1) abbilden kann. Auf der Unterseite der Abbildungsplatte (12) kann vorzugsweise eine Elektrode (17) angeordnet sein, mit der bei leitendem Werkstück (1) ein elektrisches Feld innerhalb der Kammer (2) erzeugt werden kann. Die Erfindung eignet sich insbesondere zum Ätzen eines Werkstücks (1) aus n-dotiertem Silizium mit teilweise dissoziierter Flusssäure (19) unter Einwirkung eines elektrischen Felds.

## Beschreibung

Verfahren und Vorrichtung zur lichtinduzierten chemischen Behandlung eines Werkstücks

Die vorliegende Erfindung betrifft ein Verfahren sowie eine Vorrichtung zur Durchführung von lichtinduzierten chemischen Prozessen an insbesondere ebenen Werkstücken. Derartige Prozesse laufen auf dem Werkstück nur unter Anwesenheit von Licht und den erforderlichen chemischen Stoffen ab.

Die bislang bekannten Verfahren, um auf der Oberfläche eines Werkstücks einen chemischen Prozess strukturiert lichtinduziert ablaufen zu lassen, erfordern die Anordnung einer Maske direkt auf dem Werkstück. Zur Ausbildung einer lichtundurchlässigen Maske bietet sich eine metallische Hartmaske an, die gleichförmig auf das Werkstück auftreffendes Licht dort abschattet, wo keine Reaktion stattfinden soll. Da selbst durch eine entsprechende Optik parallelisiertes Licht einen Grad an Inkohärenz aufweist, entstehen bei einem Abstand zwischen Werkstück und Maske Beugungserscheinungen. Diese Beugungserscheinungen erzwingen einen Abstand zwischen Maske und Werkstückoberfläche von höchstens 10 bis 20 µm. Dieser Abstand zwischen Werkstück und Maske ist jedoch viel zu klein, um den erforderlichen Stofftransport zur Durchführung des gewünschten lichtinduzierten, chemischen Prozesses zu ermöglichen, wenn die Chemikalien zwischen Maske und Werkstück geführt werden sollen. Insbesondere kann mit einem derart geringen Abstand kein über die Oberfläche des Werkstücks gleichförmiger Prozess erreicht werden, da keine gleichmäßige Konzentration der Chemikalien über die Oberfläche erreicht werden kann.

Soll der lichtinduzierte chemische Prozess ohne das Aufbringen einer metallischen Hartmaske direkt auf dem Wafer durchgeführt werden, so ist es bekannt, das Licht durch optische Abbildung bzw. Abrastern strukturiert auf die Oberflächen des Werkstücks direkt einstrahlen zu lassen. Derartige Verfahren sind beispielsweise Projektions- und Stepperbelichtungen, sowie Laserscanverfahren. All diese Verfahren belichten die Oberfläche des Werkstücks nicht gleichzeitig an allen Stellen, sondern immer nur einen sehr kleinen Teil der Oberfläche, wobei der übrige Bereich der Werkstückoberfläche zu einem anderen Zeitpunkt belichtet wird. Dies ist nur dann hinnehmbar, wenn die gewünschte lichtinduzierte chemische Reaktion sehr schnell abläuft, wie beispielsweise die Belichtung eines Fotolacks. Verläuft der chemische Prozess jedoch langsamer, wie beispielsweise die Ätzung von Silizium, führen diese Verfahren zu nachteilig langen Bearbeitungszeiten.

Der vorliegenden Erfindung liegt daher die Aufgabe zu Grunde, ein Verfahren sowie eine Vorrichtung zur Belichtung und chemischen Behandlung zu schaffen, bei denen bei gleichzeitiger Belichtung der gesamten Oberfläche des Werkstücks eine lichtinduzierte chemische Behandlung der Werkstückoberfläche ermöglicht wird.

Diese Aufgabe wird erfindungsgemäß durch eine Vorrichtung mit den Merkmalen des Anspruchs 1 sowie ein Verfahren mit den Merkmalen des Anspruchs 16 gelöst. Die Unteransprüche definieren jeweils bevorzugte und vorteilhafte Ausführungsformen der vorliegenden Erfindung.

Erfindungsgemäß wird das Belichtungsmuster zum Erzeugen der gewünschten Belichtung auf der Oberfläche des Werkstücks mit Hilfe einer Abbildungsplatte auf die Oberfläche des Werkstücks abgebildet. Das Belichtungsmuster wird vorteilhafterweise von einer Maske erzeugt, die zwischen einer Lichtquelle und der Abbildungsplatte angeordnet ist. Durch die Verwendung einer Abbildungsplatte kann der Abstand zwischen der Maske bzw. allgemein einer zum Erzeugen des Belichtungsmuster verwendeten Vorrichtung und der Oberfläche des Werkstücks erhöht werden, so dass die zur Durchführung der gewünschten chemischen Reaktion erforderlichen Stoffe der Oberfläche des Werkstücks zugeführt werden können und ein Kontakt zwischen der Maske und den chemischen Stoffen verhindert werden kann. Um zu verhindern, dass diese Stoffe mit Teilen in Berührung kommen und diese möglicherweise beschädigen, ist eine Kammer vorgesehen, durch die die Stoffe zur chemischen Behandlung des Werkstücks geführt werden können. Auf diese Weise können die Stoffe zur Durchführung der chemischen Reaktion sicher zum Werkstück hingeleitet werden und entstehende Reaktionsprodukte wieder abgeführt werden. Insbesondere ist es möglich, die Stoffe zur Durchführung der chemischen Reaktion in ausreichender Menge und Strömungsgeschwindigkeit über die Oberfläche des Werkstücks zu führen, so dass über die Oberfläche des Werkstücks sich konstante chemische Bedingungen einstellen. Dies ist insbesondere zur Erzielung einer über die Oberfläche des Werkstücks konstanten Reaktionsgeschwindigkeit vorteilhaft.

Die Abbildungsplatte ist insbesondere eine Anordnung von nebeneinander liegenden Linsen, wie es beispielsweise bei einem Mikrolinsenarray der Fall ist. Dabei muss die Kammer mit der Abbildungsplatte so eingerichtet sein, dass das Belichtungsmuster auf die Ebene abgebildet wird, in der die Oberfläche des zu behandelnden Werkstücks bei Anordnung des Werkstücks in der Kammer zu liegen kommt. Um eine Abbildung des Belichtungsmusters genau auf der Oberfläche des Werkstücks zu erzielen, können verschiedene Parameter beeinflusst werden. Zum einen kann der Abstand zwischen der Abbildungsplatte und dem Werkstück verändert werden. Weiterhin können die Abbildungseigenschaften wie beispielsweise die Brennweite der Abbildungsplatte verändert werden. Dabei wird vorzugsweise berücksichtigt, welchen optischen Brechungsindex die zur Behandlung des Werkstücks eingesetzten Stoffe besitzen.

Insbesondere flüssige Stoffe zur Behandlung des Werkstücks besitzen einen von Luft verschiedenen Brechungsindex, so dass die Abbildung des Belichtungsmusters durch die Stoffe in der Kammer stark beeinflusst werden können. Dies muss bei der Einrichtung der Abbildungsplatte berücksichtigt werden.

Um die Abbildungsplatte vor einem Angriff der Stoffe zur Behandlung des Werkstücks zu schützen, kann die Abbildungsplatte auf der Unterseite bzw. auf der dem Innenraum der Kammer zugewandten Seite mit einer Schutzschicht versehen sein. Diese kann beispielsweise eine Teflonbeschichtung sein. Die Beschichtung auf der Unterseite der Abbildungsplatte kann jedoch auch dazu verwendet werden, bestimmte spektrale Bereiche des einfallenden Lichts zu absorbieren oder zu reflektieren. So kann beispielsweise mit einer Beschichtung aus Silber Licht im Wellenlängenbereich zwischen 300 und 400 nm ausgefiltert werden und durch eine Beschichtung aus Gold Infrarotstrahlung abgehalten werden.

Das Material der Abbildungsplatte richtet sich nach dem Wellenlängenbereich des verwendeten Lichts. So kann beispielsweise bei sichtbaren oder UV-Licht eine Abbildungsplatte aus Quarz und bei Verwendung von Infrarotstrahlung eine Abbildungsplatte aus Silizium verwendet werden.

In einer vorteilhaften Weiterbildung der vorliegenden Erfindung ist auf der dem Innenraum der Kammer zugewandten Seite der Abbildungsplatte wenigstens eine Elektrode angeordnet. Auf diese Weise kann bei einem leitfähigen Werkstück ein elektrisches Feld zwischen der Abbildungsplatte und dem Werkstück erzeugt werden, um bestimmte chemische Prozesse auszulösen. Auf diese Weise ist es beispielsweise möglich, einen n-dotierten Siliziumwafer mit Flusssäure lichtinduziert zu ätzen.

Die Elektrode bzw. Elektroden auf der Unterseite der Abbildungsplatte können beispielsweise flächig begrenzt in den Zwischenräumen zwischen den Linsen eines Mikrolinsenarrays angeordnet sein, die ohnehin abgedunkelt werden müssen. Daneben ist es weiterhin möglich, die Elektrode bzw. Elektroden als leitfähige Beschichtung auszuführen, die in diesem Fall für das verwendete Licht durchlässig sein muss.

Vorteilhafterweise ist die Vorrichtung derart eingerichtet, dass die Kammer anstelle eines Wafers in den Strahlengang einer konventionellen Proximity-Belichtungsvorrichtung plaziert werden kann.

Die Erfindung wird nachfolgend anhand eines bevorzugten Ausführungsbeispiels unter Bezugnahme auf die beigefügten Zeichnungen näher erläutert.
Figur 1 zeigt die Anordnung einer Kammer zur lichtinduzierten chemischen Behandlung gemäß dem Ausführungsbeispiel der vorliegenden Erfindung im Strahlengang einer Proximity-Belichtungsvorrichtung,
Figur 2 zeigt in Vergrößerung den Ausschnitt A aus Figur 1, der einen Querschnitt vom Boden der Kammer bis zu der darüber angeordneten Maske zeigt, und
Figur 3 zeigt den vergrößerten Abschnitt B aus Figur 2, in dem einige Mikrolinsen der Abbildungsplatte vergrößert dargestellt sind.

Das zu bearbeitende Werkstück ist im beschriebenen Ausführungsbeispiel ein Wafer 1, der sich am Boden einer Kammer 2 befindet. Die Kammer 2 ist im Wesentlichen geschlossen und weist einen Einlass 3 und einen Auslass 4 auf, durch die flüssige und gasförmige Stoffe 19 in die Kammer 2 eingeleitet und wieder abgeführt werden können. Weiterhin weist die Kammer 2 einen Deckel 5 auf, der in wenigen Millimetern Höhe vom Boden der Kammer 2 entfernt ist. Auf dem Boden der Kammer 2 ist der zu bearbeitende Wafer 1 angeordnet.

Oberhalb der Kammer 2 ist eine Linse 8 angeordnet, mit der das Licht 9 einer Lichtquelle parallelisiert wird. Das aus der Linse 8 austretende Licht 7 fällt im Wesentlichen parallel auf die Kammer 2, auf der zum Erzeugen eines Belichtungsmusters eine Maske 6 angeordnet ist. Dazu ist die Maske 6 an einigen Stellen lichtdurchlässig und an anderen Stellen lichtundurchlässig ausgeführt, so dass das parallelisierte Licht 7 nur in bestimmten Bereichen auf die Kammer 2 fällt.

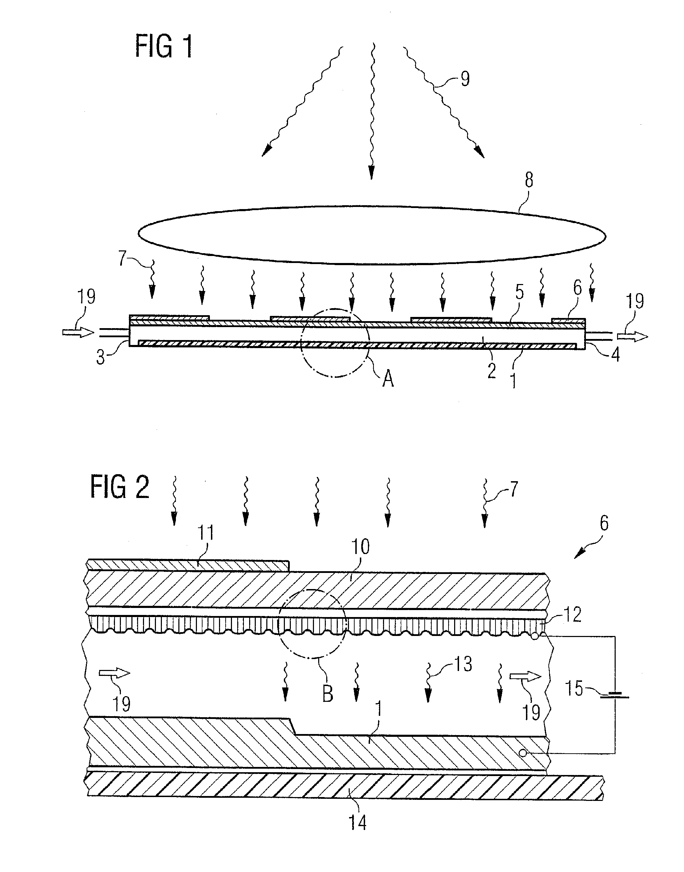

In Figur 2 ist vergrößert der Abschnitt A aus Figur 1 dargestellt, der einen Teil der Kammer 2 mit darin angeordnetem Wafer 1 zeigt. Die Kammer 2 wird nach unten durch einen Boden 14 und nach oben durch eine Abbildungsplatte 12 begrenzt, die den Deckel 5 der Kammer 2 bildet. Die Abbildungsplatte 12 ist ein Mikrolinsenarray, bei dem nebeneinander Mikrolinsen 18 angeordnet sind, die einfallendes Licht auf die Oberfläche des Wafers 1 fokussieren. Unmittelbar über dem Mikrolinsenarray 12 ist die Maske 6 angeordnet, die aus einer durchsichtigen Quarzplatte 10 besteht, auf der in bestimmten Bereichen eine Chromschicht 11 aufgebracht ist, um diese Bereiche lichtundurchlässig zu machen. Das einfallende Licht 7 kann nur in den Bereichen der Quarzplatte 10, die nicht mit einer Chromschicht 11 bedeckt sind, auf das Mikrolinsenarray 12 fallen. Das einfallende Licht 7 wird von dem Mikrolinsenarray 12 in fokussiertes Licht 13 umgewandelt, das auf dem Wafer 1 ein scharfes Belichtungsmuster erzeugt.

Auf der Unterseite des Mikrolinsenarrays 12 sind Elektroden 17 angebracht, die mit einem Pol einer Spannungsquelle 15 verbunden sind. Der andere Pol der Spannungsquelle 15 ist mit dem Wafer 1 verbunden, so dass zwischen dem Mikrolinsenarray 12 und dem Wafer 1 ein elektrisches Feld entsteht. Die Kammer 2 wird von wässriger Flusssäure 19 durchströmt, so dass die Oberfläche des Wafers 1 der Einwirkung wenigstens teilweise dissoziierter Flusssäure und eines elektrischen Felds ausgesetzt ist. Unter diesen Bedingungen wird der Wafer 1 aus n-dotiertem Silizium nur an den Stellen geätzt, auf die Licht 13 fällt. So kann durch die Ausgestaltung der Maske 6 ein Ätzmuster auf dem Wafer 1 erzeugt werden.

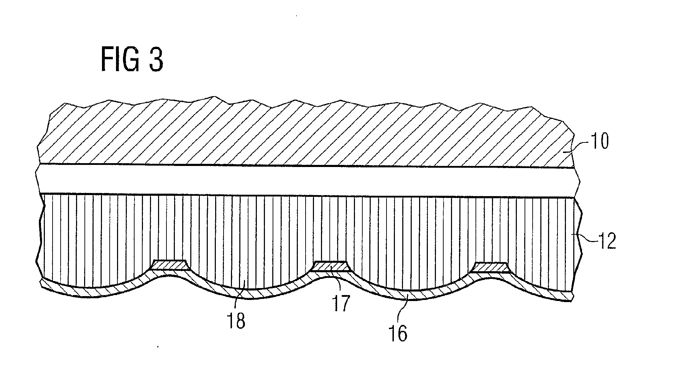

Der Ausschnitt B aus Figur 2 ist vergrößert in Figur 3 dargestellt. Dort ist ein Teil der Quarzplatte 10, der Maske 6 und darunter ein Teil des Mikrolinsenarrays 12 dargestellt. Das Mikrolinsenarray 12 besteht aus nebeneinander angeordneten Mikrolinsen 18, die zum Schutz gegen die Flusssäure 19 mit einer Beschichtung 16 aus Teflon versehen sind. Zwischen benachbarten Mikrolinsen 18 sind die Elektroden 17 angeordnet, die bei dem elektrochemischen Prozess die Kathode bilden, wohingegen der darunter angeordnete Wafer 1 als Anode geschaltet ist.

Die Geometrie der Mikrolinsen 18 muss auf den Brechungsindex des die Kammer 2 durchströmenden Stoffes 19 zur chemischen Behandlung des Wafers 1, auf die Entfernung zwischen den Mikrolinsen 18 und dem Wafer 1, sowie auf den Brechungsindex und die Dicke einer ggf. vorhandenen Beschichtung 16 auf den Mikrolinsen 18 abgestimmt sein.

Zur Verwendung von sichtbarem Licht 13 wird die Abbildungsplatte 12 vorzugsweise aus Quarz gefertigt, wohingegen sie für nahe Infrarotstrahlung aus Silizium sein kann. Weiterhin besteht die Möglichkeit, die Beschichtung 16 auf der Unterseite des Mikrolinsenarrays 12 als dünne Silberschicht auszubilden, die beispielsweise eine Dicke zwischen 10 und 100 nm aufweisen kann und die auf Grund ihrer Absorptionseigenschaften vorzugsweise Licht im Wellenlängenbereich um 350 nm hindurchlässt, so dass die Schicht 16 zum einen das Licht filtern kann als auch als Elektrode verwendet werden kann.

Mit Hilfe der erfindungsgemäßen Vorrichtung ist es möglich, die Maske 6 von dem Wafer 1 beabstandet und somit außerhalb des Stoffs 19 zur chemischen Behandlung des Wafers 1 anzuordnen. Auf diese Weise wird verhindert, dass die Maske 6 von Stoff 19 angegriffen wird, so dass die Maske 6 nicht gegenüber dem Stoff 19 resistent ausgebildet sein muss.

## Patentansprüche

1. Vorrichtung zur Belichtung und chemischen Behandlung eines Werkstücks (1),
**dadurch gekennzeichnet,**
**dass** die Vorrichtung eine Kammer (2) umfasst, die wenigstens einen Einlass (3) und wenigstens einen Auslass (4) für Stoffe (19) zur chemischen Behandlung eines in der Kammer (2) angeordneten Werkstücks (1) aufweist, wobei wenigstens ein Abschnitt (5) der Wand der Kammer von einer lichtdurchlässigen optischen Abbildungsplatte (12) zum Abbilden eines Belichtungsmusters auf der Oberfläche des in der Kammer (2) angeordneten Werkstücks (1) gebildet wird.

2. Vorrichtung nach Anspruch 1,
**dadurch gekennzeichnet,**
**dass** die Abbildungsplatte (12) derart eingerichtet ist, dass sie ein von einer außerhalb der Kammer (2) angeordneten Maske (6) erzeugtes Belichtungsmuster auf die Oberfläche des in der Kammer (2) angeordneten Werkstücks (1) fokussiert.

3. Vorrichtung nach Anspruch 2,
**dadurch gekennzeichnet,**
**dass** die Maske (6) unmittelbar auf der Abbildungsplatte (12) aufliegt.

4. Vorrichtung nach einem der vorhergehenden Ansprüche,
**dadurch gekennzeichnet,**
**dass** die Abbildungsplatte (12) derart eingerichtet ist, dass sie das Belichtungsmuster unter Berücksichtigung des Brechungsindexes der Stoffe (19) zur chemischen Behandlung des Werkstücks (1) auf die Oberfläche des in der Kammer (2) angeordneten Werkstücks (1) abbildet.

5. Verfahren nach einem der vorhergehenden Ansprüche,
**dadurch gekennzeichnet,**
**dass** die Brennweite der Abbildungsplatte (12) und ihr Abstand zu einer Sollposition für das in der Kammer (2) anzuordnendes Werkstück (1) derart eingerichtet sind, dass die Abbildungsplatte (12) das Belichtungsmuster auf die Oberfläche eines in der Kammer (2) in der Sollposition angeordneten Werkstücks (1) abbildet.

6. Vorrichtung nach einem der vorhergehenden Ansprüche,
**dadurch gekennzeichnet,**
**dass** die Abbildungsplatte ein Mikrolinsenarray (12) mit nebeneinander angeordneten Linsen (18) aufweist.

7. Vorrichtung nach einem der vorhergehenden Ansprüche,
**dadurch gekennzeichnet,**
**dass** die Abbildungsplatte (12) wenigstens in belichteten Bereichen aus Silizium besteht.

8. Vorrichtung nach einem der Ansprüche 1 bis 6,
**dadurch gekennzeichnet,**
**dass** die Abbildungsplatte (12) wenigstens in belichteten Bereichen aus Quarz besteht.

9. Vorrichtung nach einem der vorhergehenden Ansprüche,
**dadurch gekennzeichnet,**
**dass** die Abbildungsplatte (12) auf ihrer dem Innenraum der Kammer (2) zugewandten Seite eine Schutzschicht (16) aufweist, die gegenüber den Stoffen (19) zur chemischen Behandlung des Werkstücks (1) resistent sind.

10. Vorrichtung nach einem der vorangegangenen Ansprüche,
**dadurch gekennzeichnet,**
**dass** die Abbildungsplatte (12) auf ihrer dem Innenraum der Kammer (2) zugewandten Seite wenigstens eine Elektrode (17) aufweist.

11. Vorrichtung nach Anspruch 10 und 6,
**dadurch gekennzeichnet,**
**dass** die Elektrode (17) in einem Zwischenraum zwischen zwei benachbarten Linsen (18) angeordnet ist.

12. Vorrichtung nach Anspruch 10,
**dadurch gekennzeichnet,**
**dass** die Elektrode eine leitfähige Beschichtung auf der Abbildungsplatte (12) ist.

13. Vorrichtung nach einem der vorangegangenen Ansprüche,
**dadurch gekennzeichnet,**
**dass** die Abbildungsplatte (12) auf ihrer dem Innenraum der Kammer (2) zugewandten Seite eine Beschichtung aus Silber oder Gold aufweist.

14. Vorrichtung nach einem der vorangegangenen Ansprüche,
**dadurch gekennzeichnet,**
**dass** die Vorrichtung zur Verwendung von Flusssäure als Stoff (19) zur chemischen Behandlung eines Werkstücks (1) aus n-dotiertem Silizium eingerichtet ist.

15. Vorrichtung nach einem der vorangegangenen Ansprüche,
**dadurch gekennzeichnet,**
**dass** die Kammer (2) zur Anordnung anstelle eines Wafers in einer Proximity-Belichtungseinrichtung eingerichtet ist.

16. Verfahren zur Belichtung und chemischen Behandlung eines Werkstücks (1), bei welchem Verfahren eine Kammer (2) zur Aufnahme des Werkstücks (1) mit einem Belichtungsmuster belichtet wird, wobei die Kammer (2) wenigstens einen Einlass (3) und wenigstens einen Auslass (4) für Stoffe (19) zur chemischen Behandlung eines in der Kammer angeordneten Werkstücks (1) aufweist, wenigstens ein Abschnitt (5) der Wand der Kammer (2) von einer lichtdurchlässigen optischen Abbildungsplatte (12) zum Abbilden des Belichtungsmusters auf der Oberfläche des in der Kammer (2) angeordneten Werkstücks (1) gebildet wird und Stoffe (19) zur chemischen Behandlung des Werkstücks (1) durch die Kammer (2) hindurchgeleitet werden.

17. Verfahren nach Anspruch 16,
**dadurch gekennzeichnet,**
**dass** die Stoffe (19) Flusssäure aufweisen.

18. Verfahren nach Anspruch 16 oder 17,
**dadurch gekennzeichnet,**
**dass** eine Spannungsdifferenz zwischen dem Werkstück (1) und einer Elektrode (17) erzeugt wird, die auf der dem Innenraum der Kammer (2) zugewandten Seite der Abbildungsplatte (12) angeordnet ist.

19. Verfahren nach einem der Ansprüche 16 bis 18,
**dadurch gekennzeichnet,**
**dass** das Belichtungsmuster mittels einer außerhalb der Kammer (2) angeordneten Maske (6) erzeugt wird.

20. Verfahren nach einem der Ansprüche 16 bis 19,
**dadurch gekennzeichnet,**
**dass** die Kammer (2) anstelle eines Wafers in einer Proximity Belichtungsvorrichtung eingesetzt ist.

21. Verfahren nach einem der Ansprüche 16 bis 20,
**dadurch gekennzeichnet,**
**dass** das Werkstück (1) ein n-dotierter Siliziumwafer ist und einer anodischen, lichtinduzierten Flusssäureätzung unterzogen wird.
